# EUROPÄISCHE PATENTSCHRIFT

(11) **EP 3 336 624 B1**
(45) Veröffentlichungstag und Bekanntmachung des Hinweises auf die Patenterteilung: **06.02.2019**
(21) Anmeldenummer: 16205179.1
(22) Anmeldetag: 19.12.2016
(51) Int. Cl.: G05B 19/042, G05B 9/03

(54) **ANORDNUNG MIT ZWEI REDUNDANTEN BAUGRUPPEN DIE SICH GEGENSEITIG ÜBERWACHEN**
ARRANGEMENT WITH TWO REDUNDANT BOARDS WHICH MONITOR EACH OTHER
SYSTÈME COMPRENANT DEUX MODULES REDONDANTS SE SURVEILLANT MUTUELLEMENT

(43) Veröffentlichungstag der Anmeldung: 20.06.2018
(73) Patentinhaber: Siemens Aktiengesellschaft, 80333 München (DE)
(72) Erfinder: Marenski, Dirk, 76185 Karlsruhe (DE)

(56) Entgegenhaltungen:
- DE-A1-102004 034 451
- DE-T5-112013 000 204

## Beschreibung

Prozessleitsysteme wie z. B. SIMATIC PCS 7 von Siemens dienen zur Automatisierung von Prozessen in technischen Anlagen und sind üblicherweise hierarchisch durch mehrere Ebenen strukturiert. Auf der Feldebene werden mittels Feldgeräten die Zustände des technischen Prozesses erfasst (Sensoren) bzw. der Prozess gezielt beeinflusst (Aktoren). In der Steuerungsebene führen Steuerrechner (speicherprogrammierbare Steuerungen mit CPU-Einheiten) feldnahe Steuerungs- und Regelungsfunktionen aus, wobei sie Eingabewerte von den Sensoren, z. B. einem Druckmessumformer, empfangen und Ausgabewerte an die Aktoren, z. B. einen Stellungsregler für ein Regelventil, abgeben. Auf der Prozessführungsebene findet in Leitrechnern die übergeordnete Steuerung und Regelung des Prozesses statt.

Der Datenaustausch zwischen den Feldgeräten und den Steuerrechnern erfolgt üblicherweise über einen digitalen Feldbus, wie z. B. PROFIBUS DP oder PROFINET. Da die Feldgeräte normalerweise selbst keinen entsprechenden Feldbusanschluss aufweisen, werden sie über dezentrale Peripheriestationen an den Feldbus angebunden. Eine Peripheriestation besteht aus einem Interfacemodul (Kopfbaugruppe) zum Anschluss an den Feldbus und einer Anzahl von Peripheriebaugruppen (digitale und analoge Ein- und Ausgabebaugruppen) zum Anschluss der Feldgeräte. Die Peripheriebaugruppen können einen oder mehrere Kanäle aufweisen, an denen jeweils ein Feldgerät angeschlossen werden kann.

So offenbart die DE 10 2004 034 451 A1 zum Beispiel ein Steuersystem mit zwei redundanten Steuerrechnern, an denen jeweils eine Peripheriebaugruppe angeschlossen ist. An den beiden Peripheriebaugruppen ist entweder ein Aktor oder ein Sensor angeschlossen. Die beiden Steuerrechner arbeiten im ungestörten Fall gleichzeitig dasselbe Steuerprogramm ab, wobei aber nur einer von ihnen in dem Sinne aktiv ist, dass er mit seinen Ausgabewerten den Aktor steuert oder von dem Sensor erhaltene Eingabewerte verarbeitet, um so einen Prozess zu steuern. Im Fehlerfall übernimmt der andere, intakte Steuerrechner die Steuerung des Prozesses. Die Peripheriebaugruppen können durch Programmierung oder Parametrierung wahlweise als Eingabe- oder Ausgabebaugruppen betrieben werden, wobei sie redundant arbeiten.

Zur wahlweise redundanten oder nichtredundanten Erfassung von Messwerten eines Zweileiter-Messumformers enthält jede der beiden Baugruppen eine Strom- oder Spannungsquelle, die über eine Reihenschaltung aus einem ersten steuerbaren Schalter und einem ersten Stromsensor mit einem ersten Leitungsanschluss der jeweiligen Baugruppe verbunden ist. Beide Baugruppen weisen ferner jeweils einen zweiten Leitungsanschluss und einen Masseanschluss auf, zwischen denen ein zweiter Stromsensor in Reihe mit einem zweiten steuerbaren Schalter liegt. Die beiden Baugruppen sind an ihren ersten Leitungsanschlüssen über eine erste Leitung und an ihren zweiten Leitungsanschlüssen über eine zweite Leitung miteinander verbunden, wobei der Zweileiter-Messumformer zwischen beide Leitungen geschaltet ist. Je nach Schaltstellung der steuerbaren Schalter sind zwei redundante und zwei nichtredundante Betriebsarten möglich. In den redundanten Betriebsarten ist der erste Schalter in einer der beiden Baugruppen und der zweite Schalter in der jeweils anderen Baugruppe geschlossen, wobei der Messstrom des Messumformers mittels des ersten Stromsensors in der einen Baugruppe und des zweiten Stromsensors in der anderen Baugruppe redundant erfasst wird. In den nichtredundanten Betriebsarten sind der erste und zweite Schalter in nur einer der beiden Baugruppen geschlossen, wobei der Messstrom entweder von dem ersten oder dem zweiten Stromsensor in der betreffenden Baugruppe erfasst wird.

Eine gegenseitige Überwachung beider Peripheriebaugruppen ist in der DE 10 2004 034 451 A1 nicht offenbart.

Für einen ordnungsgemäßen und sicheren Redundanzbetrieb zweier Baugruppen, beispielsweise zweier Peripheriebaugruppen, ist es erforderlich, dass jede der Baugruppen über die Funktionsfähigkeit der anderen Baugruppe informiert ist, um beispielsweise ein Umschalten von einer aktiven Baugruppe auf eine nicht vorhandene oder nicht funktionsfähige Baugruppe zu verhindern.

Der Erfindung liegt daher die Aufgabe zugrunde eine gegenseitige Überwachung von zwei redundanten Baugruppen mit geringem schaltungstechnischem Aufwand zu ermöglichen, wobei die Überwachung selbst ebenfalls redundant erfolgen soll.

Gemäß der Erfindung wird die Aufgabe gelöst durch eine Anordnung mit einer ersten Baugruppe und einer redundanten zweiten Baugruppe, die einander gegenseitig überwachen, wozu
- jede der beiden Baugruppen eine Strom- oder Spannungsquelle enthält, die entweder ein- und ausschaltbar ausgebildet und über einen ersten Stromsensor mit einem ersten Leitungsanschluss der jeweiligen Baugruppe verbunden ist oder über eine Reihenschaltung aus einem ersten steuerbaren Schalter und dem ersten Stromsensor mit dem ersten Leitungsanschluss verbunden ist,
- jede der beiden Baugruppen ferner jeweils über einen zweiten Leitungsanschluss und einen Masseanschluss verfügt, zwischen denen ein zweiter Stromsensor in Reihe mit einem zweiten steuerbaren Schalter liegt,
- der erste Leitungsanschluss der ersten Baugruppe über eine erste Leitung mit dem zweiten Leitungsanschluss der zweiten Baugruppe und der erste Leitungsanschluss der zweiten Baugruppe über eine zweite Leitung mit dem zweiten Leitungsanschluss der ersten Baugruppe verbunden ist,
- jede der beiden Baugruppen dazu ausgebildet ist, im funktionsfähigen Zustand ihre Strom- oder Spannungsquelle einzuschalten und den in ihr enthaltenen zweiten steuerbaren Schalter zu schließen oder beide der in ihr enthaltenen steuerbaren Schalter zu schließen, und
- jede der beiden Baugruppen eine an den beiden in ihr enthaltenen Stromsensoren und angeschlossene Überwachungseinrichtung enthält, die ein die jeweils andere Baugruppe als funktionsfähig identifizierendes Überwachungssignal erzeugt, wenn mindestens einer der beiden Stromsensoren einen Stromfluss detektiert.

Die Leitungsanschlüsse und Leitungen der vorstehend definierten Anordnung dienen nur zum Zwecke der gegenseitigen Überwachung beider Baugruppen und nicht zum Anschluss eines Aktors oder Messumformers. Wenn also an den beiden Baugruppen der erfindungsgemäßen Anordnung ein Aktor oder Messumformer, beispielsweise in der aus der DE 10 2004 034 451 A1 bekannten Verschaltung, angeschlossen werden soll, so erfolgt dies über separate Leitungsanschlüsse und Leitungen, die nicht Gegenstand der vorliegenden Erfindung sind.

Eine Baugruppe ist in einem funktionsfähigen Zustand, wenn sie gesteckt ist, mit Strom versorgt wird und sich nicht aufgrund eines Fehlers selbst abgeschaltet hat. Die funktionsfähige Baugruppe kann aktiv aber auch in dem Sinne passiv sein, dass sie aktuell keine baugruppenspezifischen Funktionen ausführt, aber dazu aktiviert werden kann. In der erfindungsgemäßen Anordnung sind bei einer funktionsfähigen Baugruppe die steuerbaren Schalter geschlossen und beide Stromsensoren aktiv, um auf jeder der beiden Leitungen einen Stromfluss detektieren zu können. Wenn sich die andere Baugruppe ebenfalls in einem funktionsfähigen Zustand befindend, sind auch ihre steuerbaren Schalter geschlossen, so dass in beiden Leitungen ein Strom fließt. Jede der beiden Baugruppen detektiert dann einen Stromfluss in beiden Leitungen und so die Funktionsfähigkeit der jeweils anderen Baugruppen. Wenn eine der beiden Leitungen unterbrochen ist, wird von beiden Baugruppen immer noch ein Stromfluss in der anderen Leitung und so die Funktionsfähigkeit der jeweils anderen Baugruppe detektiert. Wenn dagegen eine der beiden Baugruppen funktionsunfähig ist, sind ihre steuerbaren Schalter geöffnet, so dass in keiner der beiden Leitungen ein Strom fließt und so die andere Baugruppe die Funktionsunfähigkeit der einen Baugruppe erkennt.

Da für die gegenseitige Überwachung beider Baugruppen nur detektiert werden muss, ob ein Strom fließt oder kein Strom fließt, können die Stromsensoren jeweils als Optokoppler mit einem Lichtsender (z. B. Leuchtdiode) und Lichtempfänger (z. B. Fotodiode oder Fototransistor) ausgebildet sein. Dies hat neben einem besonders geringen schaltungstechnischen Aufwand auch den Vorteil, dass aufgrund der galvanischen Trennung die Ausgangsignale der Stromsensoren unmittelbar und potentialfrei an die Überwachungseinrichtung übergeben werden.

Alternativ kann der Stromfluss anhand eines Spannungsabfalls über einem Strommesswiderstand detektiert werden. Wenn in jeder der beiden Baugruppen ein solcher Strommesswiderstand mit einem seiner Anschlüsse unmittelbar mit dem zweiten Leitungsanschluss der betreffenden Baugruppe verbunden ist und die von dort zu der anderen Baugruppe führende Leitung intakt ist, kann ein Spannungsabfall über diesem Strommesswiderstand gleichzeitig in beiden Baugruppen detektiert werden. In diesem Fall teilen sich der erste Stromsensor in der einen Baugruppe und der zweite Stromsensor in der anderen Baugruppe einen gemeinsamen Strommesswiderstand in der anderen Baugruppe, was den schaltungstechnischen Aufwand für die Detektion des Stromflusses verringert.

Bei den steuerbaren Schaltern kann es sich um Halbleiterschalter, wie z. B. Transistorschalter, oder Optokoppler handeln, wobei auch hier die Optokoppler den Vorteil einer potentialfreien Ansteuerung haben; d. h., obwohl der erste und zweite steuerbare Schalter einer Baugruppe in unterschiedlichen Stromkreisen liegen, können sie mit ein und demselben Steuersignal angesteuert werden. Wenn die Strom- oder Spannungsquelle in der jeweiligen Baugruppe ein- und ausschaltbar ist, beispielsweise im Falle einer schaltbaren Konstantstromquelle, kann der erste Schalter in der betreffenden Baugruppe entfallen.

In einer Ausgestaltung der Erfindung kann eine oder können beide Leitungen dazu genutzt werden, um für den Redundanzbetrieb nützliche Informationen auszutauschen, wozu mindestens eine der beiden Baugruppen eine Sendeeinrichtung zum Aufschalten eines, z. B. mittelwertfreien, Informationssignals auf mindestens eine der beiden Leitungen aufweist und die andere Baugruppe eine Empfangseinrichtung zum Empfang des Informationssignals enthält. Bei den Informationen kann es sich beispielsweise um einen für beide Baugruppen gültigen Steuerbefehl handeln, den die aktive Baugruppe von dem aktiven Steuerrechner erhält und an die inaktive Baugruppe weitergibt. Ersatzwerte werden anstelle von Ein- oder Ausgabewerten verwendet, wenn diese nicht vorliegen, ungültig oder unzuverlässig sind. Bei dem Ersatzwert kann es sich zum Beispiel um den von der Baugruppe zuletzt erhaltenen Ausgabewert, aber auch um einen anderen, von den betriebsmäßigen Ausgabewerten unterscheidbaren parametrierbaren Wert handeln, um z. B: einen Fehler zu melden oder den Aktor (z. B. ein Ventil) in eine sichere Position zu steuern. Indem das aufgeschaltete Informationssignal

Die Informationsübertragung von der einen Baugruppe zur anderen kann beispielsweise durch Pulsmodulation des Stromes auf einer der Leitungen erfolgen, wozu in vorteilhafter Weise der im Stromweg der betreffenden Leitung liegende steuerbare Schalter in der einen Baugruppe verwendet und von der Sendeeinrichtung mit einem bestimmten Puls-Pausen-Verhältnis oder Pulsbreitenverhältnis ein- und ausgeschaltet werden kann. Der im Stromweg der betreffenden Leitung liegende Stromsensor der anderen Baugruppe kann als funktioneller Bestandteil der Empfangseinrichtung dazu genutzt werden, den pulsmodulierten Strom zu detektieren. Auch hier erweist sich die Verwendung von Optokopplern als besonders vorteilhaft, weil dies eine potentialfreie Ansteuerung des steuerbaren Schalters bzw. eine potentialfreie Detektion des pulsmodulierten Stromes ermöglicht.

Zur weiteren Erläuterung der Erfindung wird im Folgenden auf die Figuren der Zeichnung Bezug genommen; im Einzelnen zeigen:
- Fig. 1: in schematischer Blockdarstellung ein redundantes Steuersystem mit zwei redundanten Baugruppen,
- Fig. 2: ein erstes Ausführungsbeispiel der erfindungsgemäßen Anordnung mit zwei Baugruppen, in denen Optokoppler als Schalter und Stromsensoren dienen,
- Fig. 3: ein zweites Ausführungsbeispiel der erfindungsgemäßen Anordnung mit Stromquellen und Strommesswiderständen in den Baugruppen,
- Fig. 4: ein weiteres Ausführungsbeispiel der erfindungsgemäßen Anordnung mit Spannungsquellen und Strommesswiderständen in den Baugruppen und
- Fig. 5: ein Beispiel für eine schaltbare Stromquelle.

Gleiche und funktionsgleiche Elemente mit sind mit gleichen Bezugszeichen versehen.

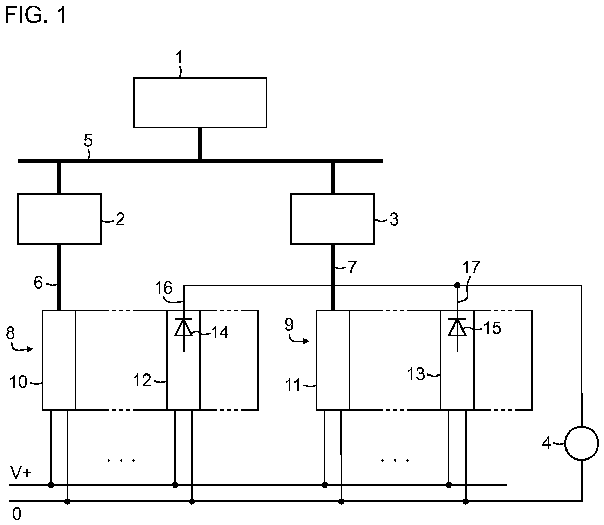

Fig. 1 zeigt einen Ausschnitt aus einem Prozessleitsystem mit einer Leiteinrichtung 1 in einer Prozessführungsebene, einem ersten und zweiten Steuerrechner 2, 3 in Form von speicherprogrammierbaren Steuerungen in einer Steuerungsebene sowie einem Aktor 4 auf Feldebene. Die Feldebene enthält weitere, hier nicht gezeigte Feldgeräte, die in Form von Sensoren die Zustände eines technischen Prozesses erfassen und als Aktoren ausgebildet den Prozess gezielt beeinflussen. Die Leiteinrichtung 1 und die Steuerrechner 2, 3 sind über einen Anlagenbus 5 (z. B. Ethernet) miteinander verbunden. Zur Erzeugung von Ausgabewerten für den Aktor 4 arbeiten die beiden Steuerrechner 2, 3 im Redundanzbetrieb jeweils ein und dasselbe Steuer- oder Anwenderprogramm ab, wobei sie u. a. über separate digitale Feldbusse 6, 7 (z. B. PROFIBUS DP) erhaltene Eingabewerte von Sensoren verarbeiten. Die Anbindung der Feldgeräte an die Feldbusse 6, 7 der beiden Steuerrechner 2, 3 erfolgt durch eine erste und eine zweite dezentrale Peripheriestation 8, 9. Jede der beiden Peripheriestationen 8, 9 besteht aus einem Interfacemodul (Kopfbaugruppe) 10, 11 zum Anschluss an den jeweiligen Feldbus 6, 7 und einer Anzahl von ein- oder mehrkanaligen Peripheriebaugruppen, von denen hier nur jeweils eine Ausgabebaugruppe 12, 13 dargestellt ist. Der Aktor 4 ist über Entkopplungsdioden 14, 15 an den Signalausgängen 16, 17 der beiden Ausgabebaugruppen 12, 13 angeschlossen. Die Interfacemodule 10, 11 übergeben Ausgabewerte, die sie von dem jeweiligen Steuerrechner 2, 3 für den Aktor 4 erhalten, an die Ausgabebaugruppen 12, 13, wobei die Dioden 14, 15 für den Aktor 4 digitale Werte disjunktiv (ODER) verknüpfen und analoge Werte (Ströme) addieren. Beide Ausgabebaugruppen 12, 13 sind aktiv. Sie erhalten im fehlerfreien Redundanzbetrieb beide dieselben Ausgabewerte. Die beiden Steuerrechner 2, 3 gleichen sich selbst entsprechend ab. Alternativ ist nur eine der beiden Baugruppen, z. B. 12, aktiv und übergibt die von der Steuerrechner 2 erhaltenen Ausgabewerte an den Aktor 4.

Die Interfacemodule 10, 11 überwachen jeweils den Feldbus 6, 7, an den sie angeschlossen sind, und geben im Falle einer Störung, beispielsweise bei Ausfall des Steuerrechners (z. B. Betriebszustand STOPP, Kabel gezogen, usw.) an alle Ausgabebaugruppen der betreffenden Peripheriestation 8, 9 einen Befehl zur Ausgabe von Ersatzwerten, beispielsweise in Form der zuletzt erhaltenen Ausgabewerte.

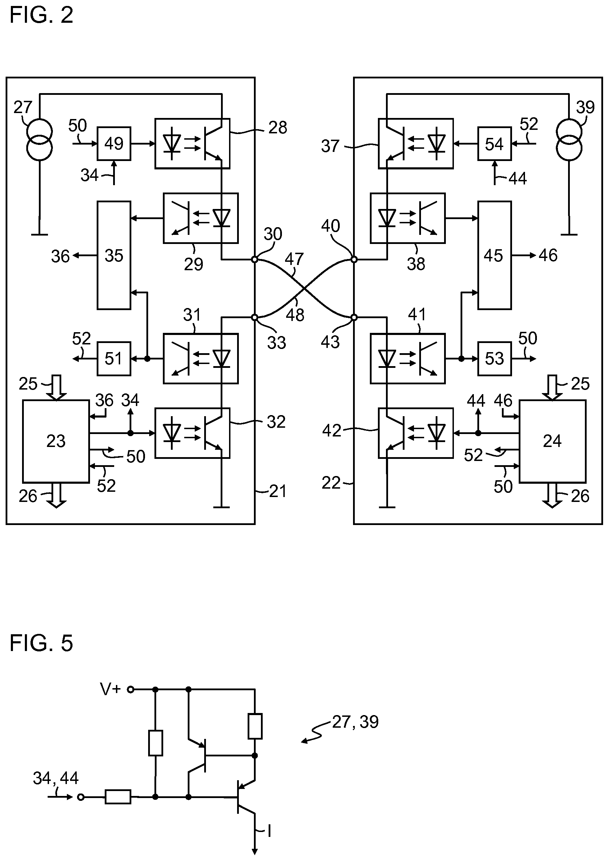

Fig. 2 zeigt ein Beispiel für die erfindungsgemäße Anordnung mit zwei redundanten Baugruppen 21, 22, bei denen es sich um die beiden Ausgabebaugruppen 12, 13 aus Fig. 1 oder jeden anderen Baugruppentyp handeln kann. Beide Baugruppen, also die erste Baugruppe 21 und die zweite Baugruppe 22 sind gleich aufgebaut und enthalten jeweils eine Funktionseinheit 23, 24 zur Ausführung baugruppenspezifischer Funktionen, im Rahmen derer Eingangsdaten 25 empfangen und Ausgangsdaten 26 erzeugt werden.

Die erste Baugruppe 21 enthält eine Stromquelle 27 (oder alternativ eine Spannungsquelle), die über eine Reihenschaltung aus einem ersten steuerbaren Schalter 28 und einem ersten Stromsensor 29 mit einem ersten Leitungsanschluss 30 verbunden ist. Die Baugruppe 21 enthält ferner einen zweiten Stromsensor 31, der in Reihe mit einem zweiten steuerbaren Schalter 32 zwischen einem zweiten Leitungsanschluss 33 und Masse liegt. Bei dem gezeigten Ausführungsbeispiel bestehen die steuerbaren Schalter 28, 32 und die Stromsensoren 29, 31 jeweils aus einem Optokoppler mit Leuchtdiode und Fototransistor.

Im funktionsfähigen Zustand, d. h. wenn die Baugruppe 21 gesteckt ist, mit Strom versorgt wird und sich nicht aufgrund eines Fehlers selbst abgeschaltet hat, erzeugt die Funktionseinheit 23 ein Steuersignal 34, mit dem die steuerbaren Schalter 28, 32 geschlossen werden. Im funktionsfähigen Zustand kann die Baugruppe 21 aktiv aber auch in dem Sinne passiv sein, dass sie aktuell keine baugruppenspezifische Funktionen ausführt, aber dazu aktiviert werden kann.

Die beiden Stromsensoren 29, 31 sind dazu vorgesehen, einen über den ersten bzw. zweiten Leitungsanschluss 30, 33 fließenden Strom zu detektieren und dies einer Überwachungseinrichtung 35 zu melden, die dann ein Überwachungssignal 36 für die Funktionseinheit 23 erzeugt, wenn mindestens einer der beiden Stromsensoren 29, 31 einen Stromfluss detektiert.

Die redundante zweite Baugruppe 22 enthält ebenfalls einen ersten steuerbaren Schalter 37 und einen ersten Stromsensor 38 zwischen einer Stromquelle 39 (oder Spannungsquelle) und einem ersten Leitungsanschluss 40 sowie einen zweiten Stromsensor 41 in Reihe mit einem zweiten steuerbaren Schalter 42 zwischen einem zweiten Leitungsanschluss 43 und Masse. Auch hier bestehen die steuerbaren Schalter 37, 42 und die Stromsensoren 38, 41 aus Optokopplern.

Im funktionsfähigen Zustand der zweiten Baugruppe 22 erzeugt die Funktionseinheit 24 ein Steuersignal 44, mit dem die steuerbaren Schalter 37, 42 geschlossen werden. Die beiden Stromsensoren 38, 41 melden einen über den ersten bzw. zweiten Leitungsanschluss 40, 43 stattfindenden Stromfluss an eine Überwachungseinrichtung 45 zu melden, die dann ein Überwachungssignal 46 für die Funktionseinheit 24 erzeugt, wenn mindestens einer der beiden Stromsensoren 38, 41 einen solchen Stromfluss meldet.

Der erste Leitungsanschluss 30 der ersten Baugruppe 21 ist über eine erste Leitung 47 mit dem zweiten Leitungsanschluss 43 der zweiten Baugruppe 22 verbunden. Eine zweite Leitung 48 verbindet den ersten Leitungsanschluss 40 der zweiten Baugruppe 22 mit dem zweiten Leitungsanschluss 33 der ersten Baugruppe 21. Der erste Stromsensor 29 in der ersten Baugruppe 21 und der zweite Stromsensor 41 in der zweiten Baugruppe 22 detektieren daher einen möglichen Stromfluss auf der ersten Leitung 47, während erste Stromsensor 38 in der zweiten Baugruppe 22 und der zweite Stromsensor 31 in der ersten Baugruppe 21 einen Stromfluss auf der zweiten Leitung 48 detektieren.

Bei Funktionsfähigkeit der ersten Baugruppe 21 sind die steuerbaren Schalter 28, 32 geschlossen und beide Stromsensoren 29, 31 aktiv, um auf jeder der beiden Leitungen 47, 48 einen Stromfluss detektieren zu können. Wenn sich die andere Baugruppe 22 ebenfalls in einem funktionsfähigen Zustand befindend, sind auch ihre steuerbaren Schalter 37,42 geschlossen, so dass in beiden Leitungen 47, 48 ein Strom fließt. Die Stromsensoren 29, 31 in der ersten Baugruppe 21 und die Stromsensoren 38, 41 in der zweiten Baugruppen 22 detektieren dann auf beiden Leitungen 47, 48 einen Stromfluss, so dass die jeweils nachgeordneten Überwachungseinrichtungen 35 bzw. 45 ein die jeweils andere Baugruppe 22 bzw. 21 als funktionsfähig kennzeichnendes Überwachungssignal 36 bzw. 46 erzeugen. Selbst wenn eine der beiden Leitungen, z. B. 47, unterbrochen ist, wird von beiden Baugruppen 21, 22 immer noch ein Stromfluss in der anderen Leitung 48 und so die Funktionsfähigkeit der jeweils anderen Baugruppe detektiert. Wenn dagegen beispielsweise die Baugruppe 22 nicht gesteckt ist oder funktionsuntüchtig ist, sind ihre steuerbaren Schalter 37, 42 geöffnet, so dass in keiner der beiden Leitungen 47, 48 ein Strom fließt und die erste Baugruppe 21 die Funktionsunfähigkeit der zweiten Baugruppe 22 daran erkennt, dass keiner der Stromsensoren 29, 31 einen Stromfluss detektiert.

Um für den Redundanzbetrieb nützliche Informationen auszutauschen, enthält die erste Baugruppe 21 eine Sendeeinrichtung 49 zum Aufschalten eines von der Funktionseinheit 23 erzeugten Informationssignals 50 auf die erste Leitung 47 und eine Empfangseinrichtung 51 zum Empfang eines über die zweite Leitung 48 von der zweiten Baugruppe 22 erhaltenen Informationssignals 52. enthält. Die Sendeeinrichtung 49 und Empfangseinrichtungen 51 werden von der Funktionseinheit 23 gesteuert. In der baugleichen zweiten Baugruppe 22 empfängt eine Empfangseinrichtung 53 das über die erste Leitung 47 von der ersten Baugruppe 21 erhaltene Informationssignal 50 während eine Sendeeinrichtung 54 das Informationssignal 52 auf die zweite Leitung 48 aufschaltet.

Bei dem gezeigten Ausführungsbeispiel erfolgt die Aufschaltung der Informationssignale 50, 52 auf die Leitungen 47, 48 durch Pulsmodulation des von den jeweiligen Stromquellen 27, 39 gelieferten Stromes, wozu die steuerbaren Schalter 28, 37 (oder alternativ die Schalter 32, 42) genutzt werden, welche somit Bestandteil der jeweiligen Sendeeinrichtung sind. Die Detektion der Pulsmodulation des Stromes und somit der Empfang der Informationssignale erfolgt durch die Stromsensoren 31, 41, welche daher Bestandteil der jeweiligen Empfangseinrichtung sind.

Wie im Folgenden erläutert, können anstelle der in Fig. 2 gezeigten Optokoppler andere Bauelemente wie z. B. elektromechanische Schalter oder Halbleiterschalter bzw. Strommesswiderstände für die steuerbaren Schalter und/oder Stromsensoren verwendet werden.

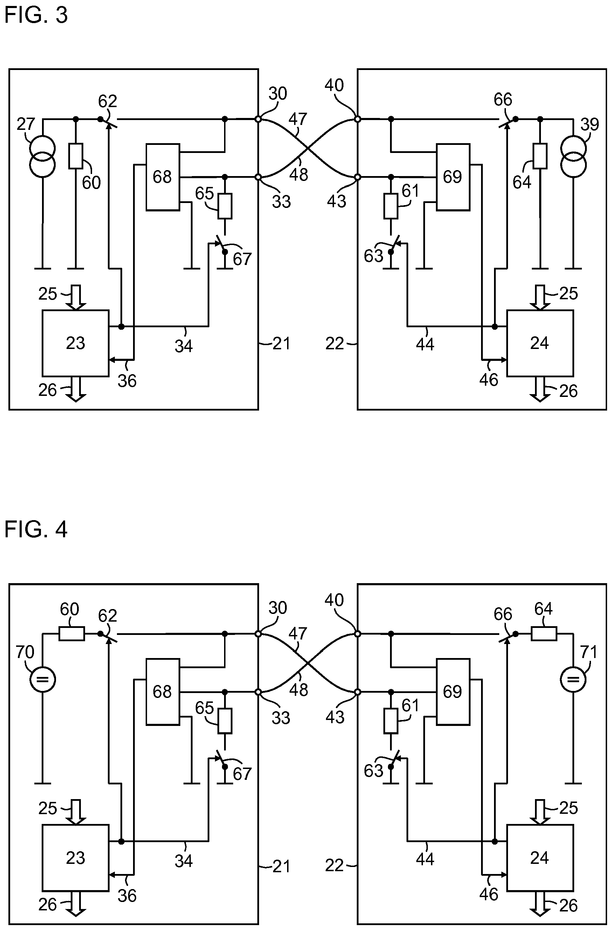

Fig. 3 zeigt ein alternatives Beispiel für die erfindungsgemäße Anordnung, bei dem die erste Stromquelle 27 in der ersten Baugruppe 21 und die zweite Stromquelle 30 in der zweiten Baugruppe 22 jeweils über einen ersten und zweiten Stromteiler mit Masse verbunden sind. Der erste Stromteiler weist einen ersten Widerstand 60 und einen zweiten Widerstand 61 auf, wobei der erste Widerstand 60 zusammen mit einem ersten steuerbaren Schalter 62 in der ersten Baugruppe 21 und der zweite Widerstand 31 in Reihe mit einen zweiten steuerbaren Schalter 63 in der zweiten Baugruppe 22 angeordnet ist. Die in den unterschiedlichen Baugruppen 21, 22 angeordneten Widerstände 60, 61 des ersten Stromteilers sind über die erste Leitung 47 miteinander verbunden. Der erste steuerbare Schalter 62 liegt zwischen der ersten Leitung 47 und der ersten Stromquelle 27 bzw. dem zu ihr parallelen ersten Widerstand 60.

Der mit der zweiten Stromquelle 39 verbundene zweite Stromteiler weist ebenfalls einen ersten Widerstand 64 und einen zweiten Widerstand 65 auf, wobei der erste Widerstand 64 zusammen mit einem ersten steuerbaren Schalter 66 in der zweiten Baugruppe 22 und der zweite Widerstand 65 in Reihe mit einen zweiten steuerbaren Schalter 67 in der ersten Baugruppe 21 angeordnet ist. Die in den unterschiedlichen Baugruppen 21, 22 angeordneten Widerstände 64, 65 des zweiten Stromteilers sind über die zweite Leitung 48 miteinander verbunden. Der erste steuerbare Schalter 66 liegt zwischen der zweiten Leitung 48 und der zweiten Stromquelle 39 bzw. dem zu ihr parallelen ersten Widerstand 64.

Der jeweils erste Widerstand 60, 64 der beiden Stromteiler führt den Strom der Stromquelle 27 bzw. 39, wenn der erste Schalter 62 bzw. 66 geöffnet ist. Dabei ist der erste Widerstand 60, 64 so bemessen, dass der Spannungsabfall an ihm einen Maximalwert nicht übersteigt. Bei realen Stromquellen 27, 39 mit Strombegrenzung kann der erste Widerstand 60, 64 von dem Innenwiderstand der betreffenden Stromquelle gebildet werden.

Die steuerbaren Schalter 62, 63, 66, 67 werden mittels der von den Funktionseinheiten 23, 24 erzeugten Steuersignale 34, 44 in der Weise angesteuert, dass die Schalter 62 und 67 in der ersten Baugruppe 21 geschlossen werden, wenn diese Baugruppe 21 funktionsfähig ist, und die Schalter 66 und 63 in der zweiten Baugruppe 22 geschlossen werden, wenn diese Baugruppe 22 funktionsfähig ist. Bei den steuerbaren Schaltern 62, 63, 66, 67 kann es sich z. B. um Halbleiterschalter, wie Transistoren oder MOSFETs, Optokoppler oder elektromechanische Schalter (Relaisschalter) handeln.

In jeder der beiden Baugruppen 21, 22 ist eine Überwachungseinrichtung 68 bzw. 69 an den beiden Leitungen 47, 48 angeschlossen, die die Spannungen zwischen jeder dieser Leitungen 47, 48 und Masse erfasst und ein die jeweils andere Baugruppe als funktionsfähig identifizierendes Überwachungssignal 36, 46 erzeugt, wenn mindestens eine der beiden erfassten Spannungen einen Wert aufweist, der dem bei geschlossenen Schaltern 62, 63, 66, 67 an den zweiten Widerständen 61, 65 zu erwartenden Spannungsabfall entspricht.

Angenommen, alle Widerstände 60, 61, 64, 65 sind gleich groß und haben der Wert R. Die Stromquellen 27, 39 liefern jeweils einen Strom I. Wenn beide Baugruppen 21, 22 funktionsfähig sind, sind alle Schalter 62, 63, 66, 67 geschlossen und beide Überwachungseinrichtungen 68, 69 erfassen an der beiden Leitungen 47, 48 jeweils eine Spannung U = I/2·R. Dies zeigt für jede der beiden Überwachungseinrichtungen 68, 69 an, dass die andere Baugruppe funktionsfähig ist.

Wenn jetzt z. B. die Leitung 48 bricht, findet kein Stromfluss durch den Widerstand 65 statt so dass der Strom I der Stromquelle 39 ausschließlich durch den Widerstand 64 fließt und einen Spannungsabfall U = I·R erzeugt. Die Überwachungseinrichtung 68 in der ersten Baugruppe 21 misst an der Leitung 47 die Spannung U = I/2·R und an der Leitung 48 den Wert Null. Die Überwachungseinrichtung 69 in der zweiten Baugruppe 22 misst an der Leitung 48 die Spannung U = I·R und an der Leitung 47 die Spannung U = I/2·R. Da mindestens eine der von der Überwachungseinrichtung 68 und mindestens eine der von der Überwachungseinrichtung 69 erfassten Spannungen U = I/2·R beträgt, stellen beide Überwachungseinrichtungen 68, 69 trotz Bruchs der Leitung 48 die Funktionsfähigkeit der anderen gegenüberliegenden Baugruppe fest.

Wenn bei intakten Leitungen 47, 48 die zweite Baugruppe 22 funktionsunfähig ist, sind deren Schalter 63, 66 geöffnet. Die Schalter 62, 67 der funktionierenden ersten Baugruppe 21 sind geschlossen. Die erste Überwachungseinrichtung 68 misst an der Leitung 47 die Spannung U = I·R und an der Leitung 48 den Wert Null. Da beide erfassten Spannungen von U = I/2·R verschieden sind, erkennt die Überwachungseinrichtung 68 so den Ausfall oder das Nichtvorhandensein der anderen gegenüberliegenden Baugruppe 22.

Wie im Beispiel nach Fig. 2 können zwischen den Baugruppen 21, 22 auszutauschende Informationen 50, 52 durch Pulsmodulation der in den Leitungen 47, 48 fließenden Ströme übertragen und empfangen werden. Bei mittelwertfreier Modulation kann der Mittelwert des Stromes auf den Leitungen 47, 48 für die gegenseitige Überwachung der Baugruppen 21, 22 verwendet werden und wird von dem für die Informationsübertragung dienenden Modulationsanteil nicht gestört. Die Informationen können auf unterschiedliche Weise, z. B. induktiv, auf die Ströme in den Leitungen 47, 48 aufmoduliert und auf gleichem Wege empfangen werden.

Fig. 4 zeigt ein weiteres Beispiel für die beiden redundanten Baugruppen 21, 22, das sich von dem nach Fig. 3 dadurch unterscheidet, dass anstelle von Stromquellen eine erste und zweite Spannungsquelle 70, 71 in den unterschiedlichen Baugruppen 21, 22 vorhanden ist. Die Widerstände 60, 61 bilden einen ersten Spannungsteiler, über den die erste Spannungsquelle 70 mit Masse verbunden ist. Die Widerstände 64, 65 bilden einen zweiten Spannungsteiler, über den die zweite Spannungsquelle 71 mit Masse verbunden ist.

Angenommen, alle Widerstände 60, 61, 64, 65 sind gleich groß und haben der Wert R. Die Spannungsquellen 70, 71 liefern jeweils eine Spannung U. Wenn beide Baugruppen 21, 22 funktionsfähig sind, sind alle Schalter 62, 63, 66, 67 geschlossen und beide Überwachungseinrichtungen 68, 69 erfassen an der beiden Leitungen 47, 48 jeweils eine Spannung U/2. Dies zeigt für jede der beiden Überwachungseinrichtungen 68, 69 an, dass die jeweils andere Baugruppe funktionsfähig ist. Im Falle einer Unterbrechung der Leitung 48 misst die Überwachungseinrichtung 68 in der ersten Baugruppe 21 an der Leitung 47 die Spannung U/2 und an der Leitung 48 den Wert Null. Die Überwachungseinrichtung 69 in der zweiten Baugruppe 21 misst an der Leitung 48 die Spannung U und an der Leitung 47 die Spannung U/2. Da mindestens eine der von der Überwachungseinrichtung 41 und mindestens eine der von der Überwachungseinrichtung 42 erfassten Spannungen U/2 beträgt, stellen beide Überwachungseinrichtungen 68, 69 trotz Bruchs der Leitung 48 die Funktionsfähigkeit der jeweils anderen gegenüberliegenden Baugruppe fest.

Fig. 5 zeigt schließlich ein Beispiel für eine Ausbildung der Stromquelle 27 bzw. 39 als schaltbare Konstantstromquelle, so dass der erste Schalter 28, 37 (Fig. 2) oder 62, 66 (Fig. 3) in der betreffenden Baugruppe 21, 22 entfallen kann.

## Patentansprüche

1. Anordnung mit einer ersten Baugruppe (21) und einer redundanten zweiten Baugruppe (22), die einander gegenseitig überwachen, wozu
- jede der beiden Baugruppen (21, 22) eine Strom- oder Spannungsquelle (27, 39) enthält, die entweder ein- und ausschaltbar ausgebildet und über einen ersten Stromsensor (29, 38) mit einem ersten Leitungsanschluss (30, 40) der jeweiligen Baugruppe verbunden ist oder über eine Reihenschaltung aus einem ersten steuerbaren Schalter (28, 37) und dem ersten Stromsensor (29, 38) mit dem ersten Leitungsanschluss (30, 40) verbunden ist,
- jede der beiden Baugruppen (21, 22) ferner jeweils über einen zweiten Leitungsanschluss (33, 43) und einen Masseanschluss verfügt, zwischen denen ein zweiter Stromsensor (31, 41) in Reihe mit einem zweiten steuerbaren Schalter (32, 42) liegt,
- der erste Leitungsanschluss (30) der ersten Baugruppe (21) über eine erste Leitung (47) mit dem zweiten Leitungsanschluss (43) der zweiten Baugruppe (22) und der erste Leitungsanschluss (40) der zweiten Baugruppe (22) über eine zweite Leitung (48) mit dem zweiten Leitungsanschluss (33) der ersten Baugruppe (21) verbunden ist,
- jede der beiden Baugruppen (21, 22) dazu ausgebildet ist, im funktionsfähigen Zustand ihre Strom- oder Spannungsquelle (27, 39) einzuschalten und den in ihr enthaltenen zweiten steuerbaren Schalter (32, 42) zu schließen oder beide der in ihr enthaltenen steuerbaren Schalter (28, 32, 37, 42) zu schließen, und
- jede der beiden Baugruppen (21, 22) eine an den beiden in ihr enthaltenen Stromsensoren (29, 31, 38, 41) angeschlossene Überwachungseinrichtung (35, 45) enthält, die ein die jeweils andere Baugruppe als funktionsfähig identifizierendes Überwachungssignal (36, 46) erzeugt, wenn mindestens einer der beiden Stromsensoren (29, 31, 38, 41) einen Stromfluss detektiert.

2. Anordnung nach Anspruch 1, **dadurch gekennzeichnet, dass** die Stromsensoren (29, 31, 38, 41) jeweils als Optokoppler ausgebildet sind.

3. Anordnung nach Anspruch 1, **dadurch gekennzeichnet, dass** die Stromsensoren jeweils einen Strommesswiderstand (61, 65) aufweisen und die Überwachungseinrichtung (68, 69) zur Erfassung eines Spannungsabfalls an dem Strommesswiderstand (61, 65) ausgebildet ist.

4. Anordnung nach Anspruch 3, **dadurch gekennzeichnet, dass** der erste Stromsensor in der jeweils einen Baugruppe (21) und der zweite Stromsensor in der jeweils anderen Baugruppe (22) einen gemeinsamen Strommesswiderstand (61, 65) in der jeweils anderen Baugruppe aufweisen, der an einer Seite mit dem zweiten Leitungsanschluss (43, 33) der jeweils anderen Baugruppe verbunden ist.

5. Anordnung nach einem der vorangehenden Ansprüche, **dadurch gekennzeichnet, dass** die steuerbaren Schalter (28, 32, 37, 42) jeweils als Optokoppler ausgebildet sind.

6. Anordnung nach einem der vorangehenden Ansprüche, **dadurch gekennzeichnet, dass** zumindest eine der beiden Baugruppen (21, 22) eine Sendeeinrichtung (49, 54) zum Aufschalten eines Informationssignals (50, 52) auf mindestens eine der beiden Leitungen (47, 48) aufweist und dass die jeweils andere Baugruppe eine Empfangseinrichtung (51, 53) zum Empfang des Informationssignals (50, 52) enthält.

7. Anordnung nach Anspruch 6, **dadurch gekennzeichnet, dass** in der zumindest einen der beiden Baugruppen (21, 22) einer der dort vorhandenen steuerbaren Schalter (28, 37) Bestandteil der Sendeeinrichtung (49, 50) ist und dass die Sendeeinrichtung (49, 50) zur Pulsmodulation eines von der Strom- oder Spannungsquelle (27, 39) gelieferten Stromes durch den steuerbaren Schalter (28, 37) ausgebildet ist.

8. Anordnung nach Anspruch 7, **dadurch gekennzeichnet, dass** in der jeweils anderen Baugruppe einer der dort vorhandenen Stromsensoren (31, 41) Bestandteil der Empfangseinrichtung (51, 53) ist, um den pulsmodulierten Strom zu empfangen.

## Claims

1. Arrangement having a first module (21) and a redundant, second module (22), which monitor one another mutually, for which purpose:
- each of the two modules (21, 22) contains a current source or voltage source (27, 39), which either is designed to be capable of being switched on and off and is connected via a first current sensor (29, 38) to a first line terminal (30, 40) of the module concerned, or is connected to the first line terminal (30, 40) via a series circuit composed of a first controllable switch (28, 37) and the first current sensor (29, 38);
- each of the two modules (21, 22) also has a second line terminal (33, 43) and a ground terminal, between which lies a second current sensor (31, 41) in series with a second controllable switch (32, 42);
- the first line terminal (30) of the first module (21) is connected via a first line (47) to the second line terminal (43) of the second module (22), and the first line terminal (40) of the second module (22) is connected via a second line (48) to the second line terminal (33) of the first module (21);
- each of the two modules (21, 22) is designed, when in the functioning state, to switch on its current source or voltage source (27, 39) and to close the second controllable switch (32, 42) contained in said module or to close both of the controllable switches (28, 32, 37, 42) contained in said module; and
- each of the two modules (21, 22) contains a monitoring device (35, 45) connected to the two current sensors contained (29, 31, 38, 41) in said module, which monitoring device generates a monitoring signal (36, 46) identifying the corresponding other module as functioning if at least one of the two current sensors (29, 31, 38, 41) detects a current flow.

2. Arrangement according to claim 1, **characterised in that** the current sensors (29, 31, 38, 41) are each embodied as optocouplers.

3. Arrangement according to claim 1, **characterised in that** the current sensors each comprise a current sensing resistor (61, 65), and the monitoring device (68, 69) is designed to detect a voltage drop across the current sensing resistor (61, 65).

4. Arrangement according to claim 3, **characterised in that** the first current sensor in the one module (21) and the second current sensor in the corresponding other module (22) have a common current sensing resistor (61, 65) in the corresponding other module, which resistor is connected at one end to the second line terminal (43, 33) of the corresponding other module.

5. Arrangement according to one of the preceding claims, **characterised in that** the controllable switches (28, 32, 37, 42) are each embodied as optocouplers.

6. Arrangement according to one of the preceding claims, **characterised in that** at least one of the two modules (21, 22) comprises a transmitter (49, 54) for applying an information signal (50, 52) to at least one of the two lines (47, 48), and **in that** the corresponding other module contains a receiver (51, 53) for receiving the information signal (50, 52).

7. Arrangement according to claim 6, **characterised in that** in the at least one of the two modules (21, 22), one of the controllable switches (28, 37) located there is part of the transmitter (49, 50), and **in that** the transmitter (49, 50) is designed for pulse modulation by the controllable switch (28, 37) of a current supplied by the current source or voltage source (27, 39).

8. Arrangement according to claim 7, **characterised in that** in the corresponding other module, one of the current sensors (31, 41) located there is part of the receiver (51, 53) in order to receive the pulse-modulated current.

## Revendications

1. Système comprenant un premier module (21) et un deuxième module (22), qui se contrôlent mutuellement, dans lequel
- chacun des deux modules (21, 22) comporte une source (27, 39) de courant ou de tension, qui ou bien est constituée de manière à pouvoir être connectée et déconnectée et est reliée par un premier capteur (29, 38) de courant à une première borne (30, 40) de ligne du module respectif ou bien est reliée par un circuit série, composé d'un premier interrupteur (28, 37) pouvant être commandé et du premier capteur (29, 38) de courant, à la première borne (30, 40) de ligne,
- chacun des deux modules (21, 22) dispose en outre d'une deuxième borne (33, 43) de ligne et d'une borne de masse, entre lesquelles un deuxième capteur (31, 41) de courant est monté en série avec un deuxième interrupteur (32, 42) pouvant être commandé,
- la première borne (30) de ligne du premier module (21) est reliée par une première ligne (47) à la deuxième borne (43) de ligne du deuxième module (22) et la première borne (40) de ligne du deuxième module (22) est reliée par une deuxième ligne (48) à la deuxième borne (33) de ligne du premier module (21),
- chacun des deux modules (21, 22) est constitué pour connecter, en l'état apte à fonctionner, sa source (27, 39) de courant ou de tension et fermer le deuxième interrupteur (32, 42) pouvant être commandé qu'il comporte ou fermer les deux interrupteurs (28, 32, 37, 42) pouvant être commandés qu'il comporte, et
- chacun des deux modules (21, 22) comporte un dispositif (35, 45) de contrôle, qui est raccordé aux deux capteurs (29, 31, 38, 41) de courant qu'il comporte et qui produit un signal (36, 46) de contrôle identifiant comme apte à fonctionner l'autre module respectif, si au moins l'un des deux capteurs (29, 31, 38, 41) de courant détecte un flux de courant.

2. Système suivant la revendication 1, **caractérisé en ce que** les capteurs (29, 31, 38, 41) de courant sont constitués chacun sous la forme d'un optocoupleur.

3. Système suivant la revendication 1, **caractérisé en ce que** les capteurs de courant ont chacun une résistance (61, 65) de mesure du courant et le dispositif (68, 69) de contrôle est constitué pour détecter une chute de tension aux bornes de la résistance (61, 65) de mesure de courant.

4. Système suivant la revendication 3, **caractérisé en ce que** le premier capteur de courant, dans le respectivement un module (21), et le deuxième capteur de courant, dans respectivement l'autre module (22), ont une résistance (61, 65) commune de mesure de courant dans respectivement l'autre module, résistance qui est reliée d'un côté à la deuxième borne (43, 33) de ligne de respectivement l'autre module.

5. Système suivant l'une des revendications précédentes, **caractérisé en ce que** les interrupteurs (28, 32, 37, 42) pouvant être commandés sont constitués chacun sous la forme d'un optocoupleur.

6. Système suivant l'une des revendications précédentes, **caractérisé en ce qu'**au moins l'un des deux modules (21, 22) a un dispositif (49, 54) d'émission pour appliquer un signal (50, 52) d'information à au moins l'une des deux lignes (47, 48) et **en ce que** respectivement l'autre module comporte un dispositif (51, 53) de réception du signal 50, 52) d'information.

7. Système suivant la revendication 6, **caractérisé en ce que**, dans le au moins un des deux modules (21, 22), l'un des interrupteurs (28, 37) pouvant être commandés, qui s'y trouvent, fait partie du dispositif (49, 50) d'émission et **en ce que** le dispositif (49, 50) d'émission est constitué par l'interrupteur (28, 37) pouvant être commandé, pour la modulation en impulsions d'un courant fourni par la source (27, 39) de courant ou de tension.

8. Système suivant la revendication 7, **caractérisé en ce que**, dans respectivement l'autre module, l'un des capteurs (31, 41) de courant, qui s'y trouvent, fait partie du dispositif (51, 53) de réception pour recevoir le courant modulé en impulsion.
